## Europäisches Patentamt

## European Patent Office

## Office européen des brevets

(11) Numéro de publication: **0 145 568**
**B1**

(12) **FASCICULE DE BREVET EUROPÉEN**

---

(45) Date de publication du fascicule du brevet:
31.05.89

(21) Numéro de dépôt: **84402366.3**

(22) Date de dépôt: **20.11.84**

(51) Int. Cl.⁴: **H 03 G 11/06,** H 03 G 11/00

---

(54) **Dispostif amplificateur-limiteur à large bande.**

---

(30) Priorité: **25.11.83 FR 8318849**

(43) Date de publication de la demande:
**19.06.85 Bulletin 85/25**

(45) Mention de la délivrance du brevet:
**31.05.89 Bulletin 89/22**

(84) Etats contractants désignés:
**DE GB NL**

(56) Documents cité:
**US-A-3 678 405**
**US-A-3 909 725**

**ELEKTRONIK, vol. 27, no. 13, novembre 1978, pages 58-60, Munich, DE; A. KUSSMAUL:
"Logarithmischer Verstärker zur Anzeigebereich-Erweiterung"
IEEE JOURNAL OF SOLID-STATE CIRCUITS, vol. SC-3, no. 4, décembre 1968, pages 397-401, New York, US; J.J. RONGEN: "Stability considerations in monolithic integrated circuit amplifier limiters"
ELECTRONICS, vol. 40, no. 6, 20 mars 1967, pages 88-89, New York, US; R.Q. LANE: "Low-cost IC's improve 45-Mhz i-f amplifier"**

(73) Titulaire: **ALCATEL THOMSON FAISCEAUX HERTZIENS, 55, rue Greffulhe, F-92300 Levallois-Perret Cédex (FR)**

(72) Inventeur: **Corlieu, Patrick, THOMSON- CSF SCPI 173, bld Haussmann, F-75379 Paris Cedex 08 (FR)**
Inventeur: **Bursztejn, Jacques, THOMSON- CSF SCPI 173, bld Haussmann, F-75379 Paris Cedex 08 (FR)**

(74) Mandataire: **Weinmiller, Jürgen, Lennéstrasse 9 Postfach 24, D-8133 Feldafing (DE)**

## Description

La présente invention se rapporte à un dispositif amplificateur-limiteur.

Il est connu d'utiliser de tels dispositifs, par exemple dans les récepteurs à large bande des faisceaux hertziens. Les dispositifs connus comportent un amplificateur à commande automatique de gain suivi d'un limiteur d'amplitude. Pour certaines applications, telles que le pointage de l'antenne d'un récepteur au maximum d'énergie reçue, il est nécessaire d'avoir une sortie annexe qui délivre une tension proportionnelle à la puissance du signal reçu; dans le cas des amplificateurs-limiteurs connus, c'est le signal de commande automatique de gain oui constitue cette tension.

Pour les dispositifs amplificateurs-limiteurs il n'existe pas d'amplificateurs à commande automatique de gain réalisés en circuits intégrés susceptibles d'être utilisés. Il en résulte que les dispositifs amplificateurs-limiteurs ont une consommation d'énergie relativement importante et sont d'un coût élevé.

La présente invention a, en particulier, pour but de réduire les inconvénients précités.

Ceci est obtenu par l'utilisation de circuits intégrés existants du type récepteurs de ligne, associés à des circuits de compensation de la distorsion linéaire amenée par ces circuits intégrés.

Le document intitulé "Low-cost IC's improve 45 MHz i-f amplifier" de Richard Q. Lane paru dans ELECTRONICS, volume 40, numéro 6, du 20 mars 1967 décrit un amplificateur en fréquence intermédiaire qui comprend quatre étages d'amplification couplés entre eux par des transformateurs. Chaque étage a un gain de 20 dB et limite au même niveau de sortie. Un signal d'entrée de forte amplitude contraint les quatre étages à limiter en séquence. Lorsque chacun des étages limite, la caractéristique de transfert chute de 20 dB. La caractéristique ainsi obtenue est proche d'une courbe logarithmique parce que les pentes des différents segments qui la composent décroissent géométriquement.

Selon l'invention, un dispositif amplificateur-limiteur, comportant 2 n (entier au moins égal à 1) circuits intégrés, couplés en série par 2n + 1 liaisons entre une entrée de signal et une sortie de signal, est caractérisé en ce que ces 2n circuits sont des circuits logiques du type récepteur de ligne de la famille à couplage par les émetteurs, et en ce que ces 2n circuits forment n paires de compensation successives et distinctes; n circuits de compensation étant associés respectivement aux n paires pour compenser la distorsion linéaire amenée par les n paires.

La présente invention sera mieux comprise et d'autres caractéristiques apparaîtront à l'aide de la description ci-après et des figures s'y rapportant qui représentent:

- la figure 1, un premier exemple d'un dispositif amplificateur-limiteur selon l'invention,
- la figure 2, un second exemple de dispositif amplificateur-limiteur selon l'invention.

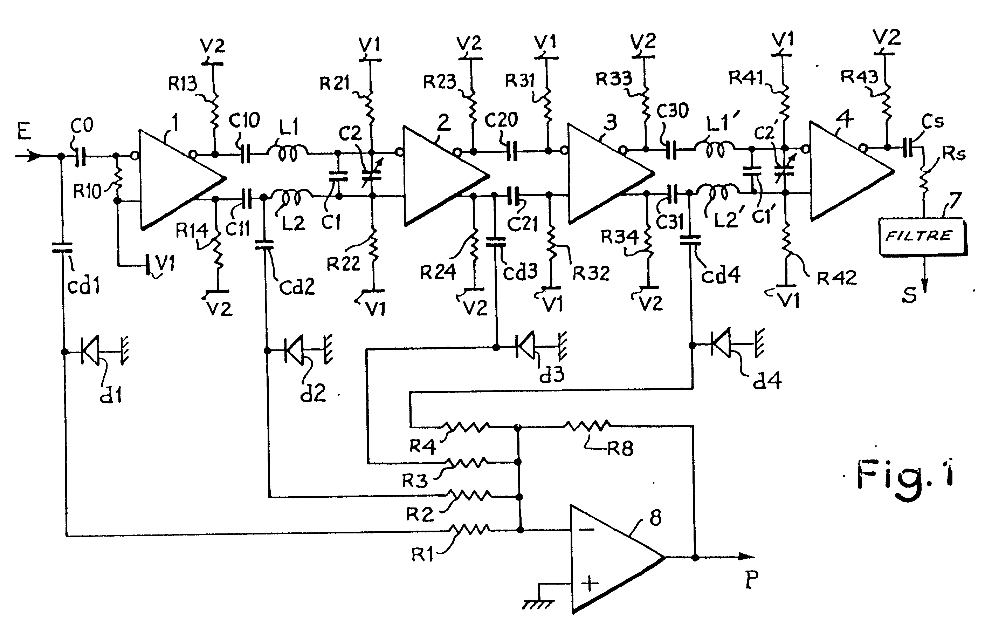

La figure 1 représente un dispositif amplificateur-limiteur auquel est adjoint un ensemble de détection permettant de fournir une mesure logarithmique de la puissance de son signal d'entrée.

Le dispositif amplificateur-limiteur selon la figure 1 peut être décrit comme un montage amplificateur-limiteur à quatre amplificateurs, 1 à 4, formés de circuits intégrés, couplés en série, avec un filtre passe-bande de sortie, 7, et, associé à ce montage, un ensemble de détection logarithmique; cet ensemble de détection effectue une détection sur les signaux appliqués aux quatre circuits intégrés, et additionne, par un additionneur de sortie, 8-R8, les signaux obtenus par détection.

La figure 1 montre une entrée de signal E sur laquelle est appliqué le signal à amplifier; il s'agit d'un signal qui doit être amplifié pour fournir, sur une sortie S, un signal à niveau constant sensiblement égal à 0 dBm, soit 1 mW, et qui doit être détecté pour fournir sur une sortie annexe, P, une tension proportionnelle à la valeur exprimée en dBm de la puissance du signal sur l'entrée E. L'entrée E est reliée par un condensateur de découplage, Co, de 1nF à l'entrée avec inversion de l'amplificateur 1 qui, comme les circuits 2 à 4, est un circuit intégré logique du type récepteur de ligne de la famille à couplage par les émetteurs (appelés, dans la littérature anglo-saxonne, emitter coupled logic ou E.C.L.), qui a la double fonction d'amplificateur et de limiteur de tension; il s'agit dans le cas présent de circuits MC 10H116. Les entrées avec inversion et directe de l'amplificateur 1 sont reliées par une résistance R10 de 51 ohms et l'entrée directe est, de plus, reliée à une source de tension V1 de -1,3 volts. Les sorties avec inversion et directe de l'amplificateur 1 sont reliées à une source de tension V2 de -5,2 volts par, respectivement, deux résistances de polarisation R13 et R14, de 390 ohms. Les sorties avec inversion et directe de l'amplificateur 1 sont également reliées par un condensateur de découplage, C10, C11, suivi d'une inductance, L1, L2 de 33 nanohenrys, respectivement aux entrées avec inversion et directe de l'amplificateur 2. Les entrées avec inversion et directe de l'amplificateur 2 sont reliées par un condensateur fixe C1 de 3,3 picofarads et un condensateur ajustable C2 montés en parallèles et ces deux entrées sont couplées à la source V1 respectivement par deux résistances R21 et R22 de 560 ohm. La liaison entre les sorties de l'amplificateur 1 et les entrées de l'amplificateur 2, telle qu'elle vient d'être décrite, est une liaison par circuit passe-bas. Ce circuit passe-bas inductance-capacitance, aussi appelé circuit L - C, est constitué par les inductances L1, L2 et les condensateurs C1, C2; il est destiné à réaliser une correction des distorsions linéaire d'amplitude de la paire d'amplificateurs 1 - 2. En effet ces amplificateurs étant constitués par des récepteurs de ligne de la famille à couplage par les émetteurs, présentent, en linéaire, une fonction de transfert à pôle unique à la pulsation wn, qui dans le cas des circuits considérés correspond à une fréquence Fn de l'ordre de 160 MHz; le circuit L - C formé des éléments L1, L2, C1, C2, introduit une fonction de transfert de la forme

$$[1 + j.w \tfrac{2r}{wn} + \tfrac{1}{wn^2} (j.w)^2]^{-1}$$

où j est la racine carrée de -1, w la pulsation et r l'amortissement dû au circuit L - C; cette fonction de transfert compense les distorsions de la paire 1 - 2 jusqu'à environ w = wn pour r voisin de 0,25.

Les sorties avec inversion et directe de l'amplificateur 2 sont reliées à la source V2 respectivement par deux résistances, R23, R24, identiques aux résistances R13 et R14; de plus les sorties avec inversion et directe de l'amplificateur 2 sont reliées respectivement aux entrées avec inversion et directe de l'amplificateur 3 par des condensateurs de découplage C20, C21. Deux résistances de polarisation, R31 et R32, de 100 ohms, relient respectivement les entrées avec inversion et directe de l'amplificateur 3 à la source de tension V1.

L'amplificateur 3 est relié à l'amplificateur 4 par une liaison identique à celle qui relie les amplificateurs 1 et 2; les amplificateurs 3 et 4 constituent ainsi une seconde paire d'amplificateurs avec leurs condensateurs de découplage, C30, C31, leur circuit L-C de compensation, L1', L2', C1', C2', et leurs résistances de polarisation, R33, R34, R41, R42, dont les éléments sont identiques respectivement aux éléments C10, C11, L1, L2, C1, C2, R13, R14, R21, R22 et dont les tensions de polarisation sont aussi les mêmes que pour les sorties de l'amplificateur 1 et les entrées de l'amplificateur 2.

La sortie avec inversion de l'amplificateur 4 est reliée par une résistance de polarisation de 390 ohms, R43, à la source de tension V2 et par un condensateur Cs de 1 nanofarad, suivi d'une résistance d'adaptation d'impédance, Rs, de 39 ohms, à l'entrée d'un filtre, 7, dont la bande est choisie en fonction de l'utilisation qui est faite du dispositif. Le dispositif, tel qu'il vient d'être décrit, présente, entre son entrée E et la résistance Rs, un gain qui peut atteindre 69 décibels avec une bande passante qui va de 10 MHz à 200 MHz.

Le signal de la sortie annexe, P, proportionnel à la valeur exprimée en décibels par rapport à un milliwatt (dBm) de la puissance du signal sur l'entrée E, est obtenu par le procédé classique de la détection logarithmique: un détecteur est placé à l'entrée des amplificateurs 1 à 4 et les tensions fournies par les détecteurs sont additionnées pour donner le signal de la sortie P. A cet effet l'amplificateur-limiteur selon la figure 1 comporte:

-quatre condensateurs de découplage, Cd1, Cd2, Cd3, Cd4, dont une première armature est reliée respectivement à une des armatures des quatre condensateurs de découplage, C0, C11, C21, C31, c'est-à-dire en des points de mesure des signaux d'entrée appliqués respectivement aux amplificateurs 1 à 4,

-quatre détecteurs à diode en parallèle, identiques, d1-R1, d2-R2, d3-R3, d4-R4, constitués chacun d'une diode du type BAT 19, telle que d1, dont l'anode est reliée à la masse et la cathode à la seconde armature du condensateur de découplage de détection de même indice (Cd1 pour la diode d1) et d'une résistance, telle que R1, dont une première extrémité est reliée à la cathode de la diode de même indice (d1 pour la résistance R1),

-un circuit sommateur obtenu par branchement des secondes extrémités des résistances de détection, R1 à R4, sur l'entrée "-" d'un amplificateur différentiel 8 dont l'entrée " + " est reliée à la masse et dont la sortie, qui constitue la sortie annexe P, est couplée par une résistance R8 de 1 mégohm à son entrée "-".

Un autre exemple de réalisation d'un dispositif amplificateur-limiteur comporte six amplificateurs, 1 à 6 semblables aux amplificateurs 1 à 4 de la figure 1, montés en série entre une entrée E et une sortie S, et constituant trois paires successives 1 - 2, 3 - 4, 5 - 6 d'amplificateurs avec, associé à chaque paire, un circuit de compensation des distorsions amenées par la paire considérée. Ces trois circuits de compensation sont des circuits de contre-réaction qui agissent entre la sortie directe du second amplificateur d'une paire et l'entrée avec inversion du premier amplificateur de la même paire. Chacun des trois circuits de contre-réaction est constitué par une résistance de 2,4 kilo-ohms, Rc1, Rc3, Rc5, branchée entre les deux accès, indiqués ci-avant, entre lesquels agit le circuit et par un condensateur de 1 nanofarad, Cc1, Cc3, Cc5, suivi d'un potentiomètre de 100 ohms, Pc1, Pc3, Pc5, ces deux éléments étant branchés entre l'entrée avec inversion du premier amplificateur de la paire considérée et la masse.

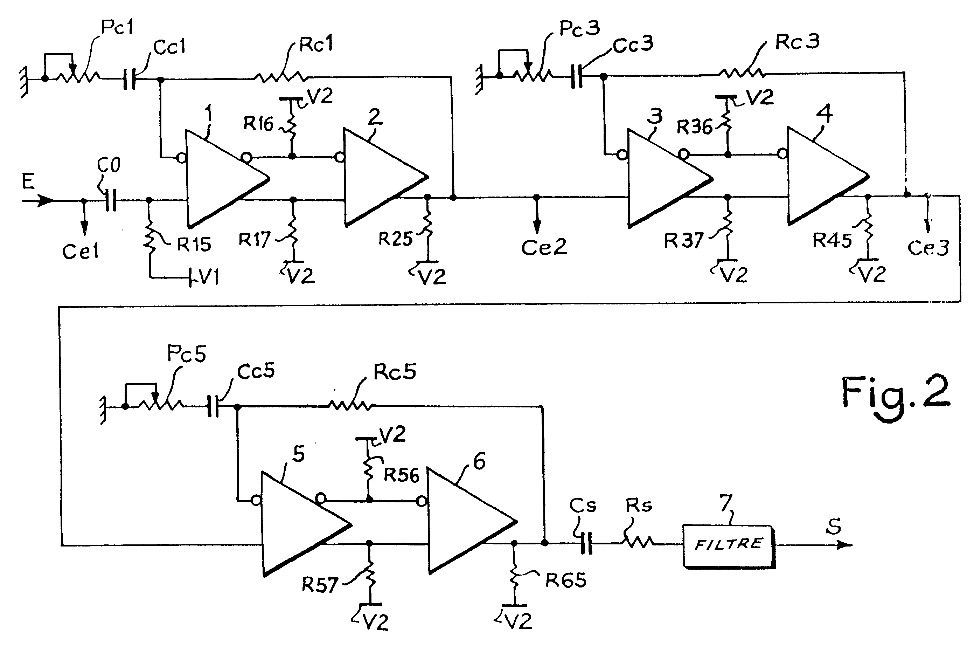

Les liaisons entre l'entrée E et la sortie S du dispositif amplificateur-limiteur selon la figure 2, consistent en:

-une liaison par un condensateur, Co, entre l'entrée E et l'entrée directe de l'amplificateur 1,

-une liaison par un condensateur, Cs, suivi d'une résistance d'adaptation d'impédance, Rs, et d'un filtre, 7, semblables aux éléments correspondants de la figure 1, entre la sortie directe de l'amplificateur 6 et la sortie S,

- une liaison par deux conducteurs entre les sorties avec inversion et directe du premier amplificateur d'une paire et respectivement les entrées avec inversion et directe du second amplificateur de la paire considérée - et une liaison par un seul conducteur entre deux paires successives, cette liaison étant réalisée entre la sortie directe du second amplificateur, 2, 4, d'une paire et l'entrée directe du premier amplificateur, 3, 5, de la paire suivante.

Sur la figure 2 sont également représentées les résistances de polarisation des entrées et des sorties directes des amplificateurs 1 à 6 ainsi que, dans chaque paire, les résistances de polarisation de la sortie avec inversion du premier amplificateur de la paire considérée et de l'entrée avec inversion du second amplificateur de la même paire. Il s'agit des résistances suivantes: R15 branchée entre l'entrée directe de l'amplificateur 1 et une source de tension V1 de -1,3 volts, R16 et R17 entre respectivement les sorties avec inversion et directe de l'amplificateur 1 et une source de tension V2 de -5,2 volts, R25 entre la sortie directe de l'amplificateur 2 et la source V2, R36 et R37 entre respectivement les sorties avec inversion et directe de l'amplificateur 3 et la source V2, R45 entre la sortie directe de l'amplificateur 4 et la source V2, R56 et R57 entre respectivement les sorties avec inversion et directe de l'amplificateur 5 et la source V2, et R65 entre la sortie directe de l'amplificateur 6 et la source V2.

Le circuit, tel qu'il vient d'être décrit à l'aide de la figure 2, fournit, sur sa sortie S, un signal à niveau constant égal à 1 mw. Il présente un gain de 80 dB et une bande passante de 300 MHz. Il est à remarquer que le gain moyen par amplificateur est plus faible que dans le cas de la réalisation selon la figure 1 : 80 dB pour six amplificateurs au lieu de 69 dB pour quatre amplificateurs, par contre, dans ce dispositif amplificateur-limiteur à compensation par contre-réaction, la qualité de la transmission est améliorée par rapport à ce qui est obtenu avec le dispositif selon la figure 1.

Sur la figure 2 l'ensemble de détection logarithmique, qui permet de fournir une tension proportionnelle à la puissance en décibels par rapport à un milliwatt, du signal appliqué sur l'entrée E n'a pas été représenté. Ceci a permis de rendre le dessin plus clair sans nuire à la compréhension de certains détails de l'invention; en effet l'ensemble de détection logarithmique en question est semblable à celui de la figure 1 à cela près qu'il comporte non pas quatre mais trois détecteurs à diode, dont les signaux de sortie sont additionnés grâce à un additionneur semblable à l'additionneur 8-R8 de la figure 1; de plus, sur la figure 2 à partir de l'entrée E et des sorties directes des amplificateurs 2 et 4, ont été indiqués les conducteurs allant vers les condensateurs de découplage, Ce1 à Ce3, non représentés, placés, comme sur la figure 1, à l'entrée de chacun des détecteurs à diode de l'ensemble de détection logarithmique. Il est à remarquer que l'ensemble de détection du dispositif selon la figure 2 ne comporte pas d'entrées de détection reliées aux liaisons entre, respectivement, les sorties des amplificateurs 1, 3, 5 et les entrées des amplificateurs 2, 4, 6; c'est que, dans ces trois liaisons, la tension n'est pas, du fait de la contre-réaction, représentative du signal transmis de l'entrée E vers la sortie S.

L'invention ne se limite pas aux deux exemples décrits. C'est ainsi que le dispositif amplificateur-limiteur peut comporter une seule paire d'amplificateurs avec son circuit de compensation associé ou bien plus de trois paires avec chacune leur circuit de compensation; de même d'autres circuits de compensation associés à une paire d'amplificateurs peuvent être utilisés et, éventuellement, lorsque le nombre de paires est au moins égal à deux, le circuit de compensation peut être différent d'une paire à l'autre.

## Revendications

1. Dispositif amplificateur-limiteur, comportant 2 n (n entier au moins égal à 1) circuits intégrés (1 - 4; 1 - 6), couplés en série par 2n + 1 liaisons entre une entrée de signal (E) et une sortie de signal (S), caractérisé en ce que ces 2n circuits sont des circuits logiques du type récepteur de ligne de la famille à couplage par les émetteurs, et en ce que ces 2n circuits forment n paires de compensation (1 - 2, 3 - 4; 1 - 2, 3 - 4, 5 - 6) successives et distinctes; n circuits de compensation (L1- L2-C1-C2, L1'-L2'-C1'-C2'; Rcl-Cc1-Pc1, Rc3-Cc3-Pc3; Rc5-Cc5-Pc5) étant associés respectivement aux n paires pour compenser la distorsion linéaire amenée par les n paires.

2. Dispositif amplificateur-limiteur selon la revendication 1, caractérisé en ce que les n circuits de compensation sont des circuits passe-bas inductance-capacité (L1-L2-C1-C2, L1'-L2'-C1'-C2'), respectivement branchés dans les n liaisons entre les circuits intégrés d'une même paire (1 - 2, 3 - 4).

3. Dispositif amplificateur-limiteur selon la revendication 1, caractérisé en ce que les n circuits de compensation sont des circuits de contre-réaction (Rc1-Cc1-Pc1, Rc3-Cc3-Pc3, Rc5-Cc5-Pc5) et en ce que, pour chaque paire, le circuit de contre-réaction associé couple la liaison suivant immédiatement la paire considérée à une entrée de contre-réaction de celui des deux circuits intégrés de la paire considérée qui est en amont de l'autre circuit intégré de cette même paire (1 - 2, 3 - 4, 5 -6).

4. Dispositif amplificateur-limiteur selon l'une des revendications 1 et 2, caractérisé en ce qu'il comporte un ensemble de détection logarithmique pour fournir une tension proportionnelle à la valeur logarithmique de la puissance du signal à amplifier par le dispositif amplificateur-limiteur, cet ensemble comportant: 2n détecteurs (d1-R1, d2-R2, d3-R3, d4-R4) respectivement couplés à l'entrée de signal et aux 2n-1 liaisons entre les 2n circuits intégrés pour réaliser une détection sur les signaux appliqués à ces 2n circuits intégrés; et un circuit sommateur (8-R8) pour réaliser une sommation des signaux fournis par les 2 n détecteurs.

5. Dispositif amplificateur-limiteur selon l'une des revendications 1 et 3, caractérisé en ce qu'il comporte un ensemble de détection logarithmique (8') pour fournir une tension proportionnelle à la valeur logarithmique de la puissance du signal à amplifier par le dispositif amplificateur-limiteur, cet ensemble comportant: n détecteurs respectivement couplés à l'entrée de signal (E) et aux n-1 liaisons entre les n paires de circuits intégrés pour réaliser une détection sur les signaux appliqués à ces n paires; et un circuit sommateur pour réaliser une sommation des signaux fournis par les n détecteurs.

## Patentansprüche

1. Verstärker-Begrenzerschaltung mit 2n durch 2n + 1 Verbindungen zwischen einem Signaleingang (E) und einem Signalausgang (S) in Reihe geschalteten integrierten Schaltkreisen (1 - 4; 1 - 6), wobei n eine ganze Zahl, mindestens gleich 1 ist, dadurch gekennzeichnet, daß die 2n Schaltkreise logische Kreise vom Leitungsempfängertyp mit Emitterkopplung sind, und daß diese 2n Schaltkreise n aufeinanderfolgende und getrennte Kompensationspaare (1 - 2, 3 - 4; 1 - 2, 3 - 4, 5 - 6) bilden, wobei n Kompensationskreise (L1-L2-C1-C2; L1'- L2'-C1'-C2'; Rc1-Cc1-Pc1, Rc3-Cc3-Pc3; Rc5-Cc5-Pc5) jeweils einem der n Paare zugeordnet sind, um die durch die n Paare herbeigeführte lineare Verzerrung zu kompensieren.

2. Verstärker-Begrenzerschaltung nach Anspruch 1, dadurch gekennzeichnet, daß die n Kompensationskreise LC-Tiefpaßfilter (L1-L2-C1-C2, L1'-L2'-C1-C2') sind, die jeweils in die n Verbindungen zwischen den integrierten Schaltkreisen eines Paares (1 - 2, 3 - 4) eingefügt sind.

3. Verstärker-Begrenzerschaltung nach Anspruch 1, dadurch gekennzeichnet, daß die n Kompensationskreise Rückkopplungskreise (Rc1-Cc1-Pc1, Rc3-Cc3-Pc3, Rcs-Cc5-Pc5) sind, und daß bei jedem Paar der zugehörige Rückkopplungskreis die unmittelbar auf das betrachtete Paar folgende Verbindung an einen Rückkopplungseingang desjenigen der beiden integrierten Schaltkreise des betrachteten Paares ankoppelt, welcher in der Schaltung vor dem anderen integrierten Schaltkreise desselben Paares (1 - 2, 3 - 4, 5 - 6) liegt.

4. Verstärker-Begrenzerschaltung nach einem der Ansprüche 1 und 2, dadurch gekennzeichnet, daß sie eine logarithmische Detektorschaltung zur Lieferung einer Spannung aufweist, welche zum logarithmischen Wert der Leistung des durch die Verstärker-Begrenzerschaltung zu verstärkenden Signals proportional ist, wobei diese Detektorschaltung 2n Detektoren (d1-R1, d2-R2, d3-R3, d4-R4), die an den Signaleingang bzw. an je eine der 2n-1 Verbindungen zwischen den 2n integrierten Schaltkreisen angekoppelt sind, um die an die 2n integrierten Schaltkreise angelegten Signale zu erfassen, und einen Summierkeis (8-R8) zur Durchführung einer Summierung der von den 2n Detektoren gelieferten Signale aufweist.

5. Verstärker-Begrenzerschaltung nach einem der Ansprüche 1 und 3, dadurch gekennzeichnet, daß sie eine logarithmische Detektorschaltung (8') zur Lieferung einer Spannung aufweist, welche zum logarithmischen Wert der Leistung des durch die Verstärker-Begrenzerschaltung zu verstärkenden Signals porportional ist, wobei diese Detektorschaltung n Detektoren, die an den Signaleingang (E) bzw. an je eine der n-1 Verbindungen zwischen den n integrierten Schaltkreisen angekoppelt sind, um die an den an diese n Paare angelegten Signale zu erfassen und einen Summierkeis zur Durchführung einer Summierung der von den n Detektoren gelieferten Signale aufweist.

## Claims

1. An amplifier-limiter device comprising 2n integrated circuits (1 - 4; 1 - 6) (n being an integer at least equal to 1) , connected in series by 2n + 1 connections between a signal input (E) and a signal output (5), characterized in that these 2n circuits are logic circuits of the emitter coupled line receiver type and that these 2n pairs of circuits form n successive and separate compensation pairs, (1 - 2, 3 - 4; 1 - 2, 3 - 4, 5 - 6), n compensation circuits (L1-L2-C1-C2, L1'-L2'-C1'-C2'; Rc1-Cc1-Pc1, Rc3-Cc3 -Pc3; Rc5-Cc5-Pc5) being associated with the n pairs respectively, for compensating the linear distorsion caused by the n pairs.

2. An amplifier-limiter device according to claim 1, characterized in chat the n compensation circuits are low-pass LC-circuits (L1-L2-C1-C2, L1'-L2'-C1'-C2') inserted respectively into the n links between the integrated circuits of one and the same pair (1 - 2, 3 - 4).

3. An amplifier-limiter according to claim 1, characterized in that the n compensation circuits are feedback circuits (Rc1-Cc1-Pc1, Rc3-Cc3-Pc3, Rc5-Cc5-Pc5) and that for each pair, the associated feedback circuit couples the connection immediately following the pair in question to a feedback input of that of the two integrated circuits of the pair in question which is closer to the signal input than the other integrated circuit of that pair (1 - 2, 3 - 4, 5 - 6).

4. An amplifier-limiter device according to one of claims 1 and 2, characterized in that it comprises a logarithmic detector assembly intended to provide a voltage proportional to the logarithmic value of the power of the signal to be amplified by the amplifier-limiter device, this assembly comprising: 2n detectors (d1-R1, d2-R2, d3-R3 , d4-R4) respectively coupled to the signal input and to the 2n-1 connections becween the 2n integrated circuits to perform a detecting operation on the signals fed to these 2n integrated circuits, and a summing circuit (8-R8) for performing a summing operation on the signals provided by the 2n detectors.

5. An amplifier-limiter device according to one of claims 1 and 3, characterized in that it comprises a logarithmic detector assembly (8') for providing a voltage proportional to the logarithmic value of the power of the signal to be amplified by the amplifier-limiter device, this assembly comprising: n detectors respectively coupled to the signal input (E) and to the n-1 connections between the n pairs of integrated circuits to perform a detecting operation on the signals fed to these n pairs, and a summing circuit for performing a summing operation on the signals provided by the n detectors.

Fig.1

Fig.2